# EUROPEAN PATENT APPLICATION

(11) **EP 4 711 490 A1**
(43) Date of publication of application: **18.03.2026**
(21) Application number: 24200832.4
(22) Date of filing: 17.09.2024
(51) Int. Cl.: C23C 14/30, C23C 14/52, C23C 14/54, C23C 14/08, H01J 37/305, H01J 37/304

(54) **METHOD AND DEVICE CONFIGURED TO CONTROL A COATING APPARATUS**

(71) Applicant: Carl Zeiss Vision International GmbH, 73430 Aalen (DE)
(72) Inventor: KOENEN, Timo, 73430 Aalen (DE)
(74) Representative: Pearl Cohen EU

(57) **Abstract**

A computer-implemented method (100, 200, 300) configured to control a coating apparatus (3), the coating apparatus (3) being configured to vapor deposit a layer (51, 52) of a coating (5) onto a spectacle lens (4) by electron beam evaporation, characterized in that the method comprises automated determining (201) of an initial strength of an emission current of a current cycle of applying the coating (5) onto the spectacle lens (4) as a function of a strength of an emission current used during a previous cycle of applying the coating (5) onto the spectacle lens (4).

## Description

The present disclosure is directed to a computer-implemented method and a device configured to control a coating apparatus, respectively. A corresponding computer program and/or computer-readable medium may be provided as well as a method for manufacturing a spectacle lens.

Some substrates, in particular optical substrates, such as spectacle lenses, are often subject to a coating process during their manufacturing process. In some cases, an anti-reflection coating may be applied to substrates.

In the field of anti-reflection coating, the coating may be vapor-deposited using different coating processes depending on the product and refractive index thereof.

One coating process that may be used is electron-beam physical vapor deposition, or EBPVD, which is a form of physical vapor deposition in which a target material is bombarded with accelerated electrons under high vacuum. The electrons cause atoms from the target to transform into the gaseous phase. These atoms then precipitate into solid form, coating everything in the vacuum chamber (within line of sight) with a thin layer of the anode material.

The materials that may be vapor-deposited onto the substrate using EBPVD may comprise SiO2, Ti205, ZrO2 and ITO (indium tin oxide). The coating may comprise one or more layers of one or more anode materials, e.g. more than seven layers. The layers of the coating may also be layer packages, i.e. the same or different materials may be vapor-deposited several times in separate, optionally consecutive, layers.

One parameter or process variable that may ensure that the respective layers of the coating have desired properties may be a coating rate (optionally expressed in nm/s). For each layer of the coating, a target coating rate may be stored in process data associated with the coating. An actual coating rate during depositing a respective layer onto the substrate may be used as a feedback control variable.

Based on a comparison of the target and the actual coating rate an emission current strength (optionally expressed in mA) of a coating apparatus may be controlled.

An emission current of the electron beam may be defined as the amount or number of electrons emitted from the cathode as a function of the exit area. The emission current strength or strength of the emission current or amperage of the emission current may be defined as the current strength used to power the cathode.

The emission current depends on the emission current strength. That is, the process variable that may ensure that the target rate is achieved and/or maintained may be the emission current strength.

More specifically, for each layer the manufacturing process of the coating may comprise a respective cycle. At the beginning of each cycle the material to be deposited onto the substrate is first heated up with closed shutter(s). Therefore, the coating apparatus may, optionally continuously, increase the emission current strength and consequently the emission current. Once the heating (sequence) is completed, the shutter(s) may be opened. The coating apparatus may then begin to, optionally continuously, measure the actual coating rate using an oscillating quartz of the coating apparatus. More specifically, a resonant frequency of the quartz may be measured which may be converted into the actual coating rate.

Ideally, at the beginning of each cycle, the emission current strength is already set so that readjustment thereof is not necessary or only necessary to a small extent. More specifically, if the actual coating rate does not match the target coating rate during any time in the cycle, the actual coating rate is changed or adapted by a control device through changing or adapting the emission current strength. Depending on the delta between the actual coating rate and the target coating rate it takes the control device a certain time until the actual coating rate matches the target coating rate. In this phase, in which the target and the actual coating do not match, different effects can occur. For example, an evaporation cone can change so that different amounts of material reach different points in a segment (viewed from top to bottom). A "segment" may relate to a part of a calotte-shaped substrate holder, wherein each segment may have the shape of a hemispherical sector. Multiple segments together may form the calotte-shaped substrate holder having the shape of a hemisphere. Moreover, a refractive index of the vaporized material can change. Both effects may lead to a change in a reflective color in general or even within a calotte (i.e. segment). Those effects may thus have a negative impact on the quality of the respective layer and thus on the coating as a whole.

Additionally, besides of the above explained corrections of the actual coating range that may be necessary due to an inaccurate emission current strength at the beginning of the cycle, corrections to the set emission current strength may be necessary, as the cathode of the electron gun, more specifically the filament thereof, ages as production continues.

Moreover, corrections may be necessary when the cathode has reached the end of its life and a new one has been installed. Then, the emission current strength for the individual layers needs to be adjusted.

Conventionally, so called escalations are programmed into the control software executed by the coating apparatus. An escalation is configured to trigger a warning (signal) in the event of slight emission current strength adjustments during the coating process. That is, a conventional control software executed by the coating apparatus may be configured to adjust the emission current strength during a cycle of applying the coating onto the substrate as long as the amount by which the emission current strength needs to be adjusted is below a predefined threshold. If a greater adjustment is required, the escalation is configured to trigger an error (signal). That is, the conventional control software executed by the coating apparatus may be configured to stop applying the coating onto the substrate thereby stopping the manufacturing process of the coating when the amount by which the emission current strength needs to be adjusted is above the predefined threshold. Conventionally, the emission current strength is then corrected manually and the manufacturing process is started again.

The above described control software comprising the above described escalations may be interpreted as being the closest prior art for the present disclosure.

One object of the present disclosure may be to reduce or minimize the need for adjusting the emission current strength during the actual or present cycle of applying the coating onto the substrate.

This object is solved by the features of the independent claims. The dependent claims are directed to optional further developments of the disclosure.

Accordingly, the object is solved by a computer-implemented method configured to control a coating apparatus. The coating apparatus is configured to vapor deposit a layer of a coating onto a spectacle lens by electron beam evaporation. The method comprises an automated determining of an initial strength of an emission current of a current cycle of applying the coating on the spectacle lens as a function of a strength of an emission current used during a previous cycle of applying the coating onto the spectacle lens.

Additionally, or alternatively, the object is solved by a device being configured to control a coating apparatus. The coating apparatus is configured to vapor deposit a layer of a coating onto a spectacle lens by electron beam evaporation. The device is configured to carry out an automated determining of an initial strength of an emission current of a current cycle of applying the coating on the spectacle lens as a function of a strength of an emission current used during a previous cycle of applying the coating on the spectacle lens.

Additionally, or alternatively, the object is solved by a computer program, wherein the computer program comprises instructions which, when the program is executed by a computer, cause the computer to control a coating apparatus. The coating apparatus is configured to vapor deposit a layer of a coating onto a spectacle lens by electron beam evaporation. Controlling the coating apparatus comprises an automated determining of an initial strength of an emission current of a current cycle of applying the coating on the spectacle lens as a function of a strength of an emission current used during a previous cycle of applying the coating onto the spectacle lens

Additionally, or alternatively, the object is solved by a computer-readable storage medium, wherein the medium comprises instructions which, when executed by a computer, cause the computer to control a coating apparatus. The coating apparatus is configured to vapor deposit a layer of a coating onto a spectacle lens by electron beam evaporation. Controlling the coating apparatus comprises an automated determining of an initial strength of an emission current of a current cycle of applying the coating on the spectacle lens as a function of a strength of an emission current used during a previous cycle of applying the coating onto the spectacle lens.

Additionally, or alternatively, the object is solved by a method for manufacturing a spectacle lens. The method comprises applying a coating onto the spectacle lens in a coating apparatus. The method comprises controlling the coating apparatus using a method according to the disclosure for applying the coating onto the spectacle lens.

In other words, a solution for an automated determination of the initial emission current strength is provided.

The term electron beam evaporation is used as a synonym to the electron-beam physical vapor deposition described above. Therefore, the above given description with respect to the electron-beam physical vapor deposition applies analogously to the method(s) and device(s) of the present disclosure.

The term control may be defined as determining, and optionally to output said control signal to the coating apparatus. The control signal may be suitable to cause the coating apparatus to carry out a certain action or to stop or refrain from carrying out a certain action.

Here, the control signal may be configured to cause the coating apparatus to apply, more specifically vapor deposit, a layer of a material onto the substrate, here a spectacle lens, using an emission current strength specified, directly or indirectly, in the control signal.

The initial emission current strength or the emission current of an initial strength may be defined as the strength of the emission current that is used when beginning to vapor deposit the layer onto the substrate. That is, the emission current strength may be reached by the coating apparatus as soon as shutter(s) of the coating apparatus open and the coating is applied onto the substrate.

As generally understood and defined in section 3.5.2 of ISO 13666:2019 (E), a spectacle lens may be an ophthalmic lens according to section 3.5.1 of ISO 13666:2019 (E) worn in front of, but not in contact with, the eyeball.

As far as the description refers to spectacle lens, a substrate for the spectacle lens may be meant. The substrate may be an optical substrate for manufacturing a spectacle lens from the substrate. The substrate may have suitable dimensions for manufacturing one spectacle lens from one substrate. The substrate may form a precursor for an optical product. Alternatively, the substrate may be an (uncut) almost finished optical product which will be finished after completion of the coating process. The substrate may be a spectacle lens blank, a semi-finished spectacle lens product or a finished spectacle lens product and may in particular meet requirements specified in EN ISO 13666:2012. "Multiple substrates for spectacle lenses" may mean multiple substrates, wherein each substrate is intended for manufacturing one spectacle lens based on the respective substrate. Throughout the disclosure, the term "substrate" may in general relate to a substrate for a spectacle lens unless explicitly specified otherwise.

The coating may be an anti-reflex or anti-reflection coating. An anti-reflex, antireflective, antiglare or anti-reflection (AR) coating is a type of optical coating applied to a surface of an optical element, such as spectacle lenses, to reduce reflection. AR coatings may consist of or comprise transparent thin film structures with alternating layers of contrasting refractive index. Layer thicknesses may be chosen to produce destructive interference in the beams reflected from the interfaces, and constructive interference in the corresponding transmitted beams.

The term cycle may be defined as the timespan needed to apply or vapor deposit one layer of the coating onto the substrate. That is, the cycle may begin with opening the shutter(s) of the coating apparatus and may end with closing the shutter(s) of the coating apparatus.

The previous cycle may or may not be the cycle carried out by the coating apparatus prior to the current cycle.

The term automated may be interpreted as using soft- and/or hardware components specifically adapted or designed to carry out a predefined function, here - inter alia - to determine the initial strength of the emission current.

As far as the present disclosure refers to a computer-implemented method, the method may comprise at least one step that is at least partly and/or temporarily carried out by a computer.

The computer may be or comprise the above specified device being configured or adapted to carry out the herein specified method at least partly. Therefore, the computer may be configured to executed the computer program described herein. To do so, the computer may comprise and/or may be access a computer-readably medium as described herein.

As explained above, also a computer program may be provided. The computer program may comprise instructions which, when the program is executed by a computer, cause the computer to at least partly execute the method described herein.

A program code of the computer program may be in any code, in particular in a code suitable for control systems of coating apparatuses.

As explained above, also a computer-readable medium, optionally a computer-readable storage medium, may be provided. The computer-readable medium may comprise instructions which, when the program is executed by a computer, cause the computer to at least partly execute the method described herein.

That is, a computer-readable medium comprising a computer program as defined above may be provided.

The computer-readable medium can be any digital data storage device, such as a USB stick, a hard disk, a CD-ROM, an SD card or an SSD card.

The computer program does not necessarily have to be stored on such a computer-readable storage medium in order to be made available to the computer, but can also be obtained via the Internet or otherwise externally. That is, the computer-readably medium may be a data signal comprising instructions which, when the data signal is received by the computer and the instructions are carried out by the computer, cause the computer to carry out the method described herein at least partly.

What is described herein with reference to the method also applies analogously or mutatis mutandis to the device, the computer program and the computer-readable medium and vice versa.

The solution according to the present disclosure comprises, as a distinguishing feature of the above identified closest prior at, an automated determining of the initial strength of the emission current as a function of a strength of an emission current used during a previous cycle of applying the coating onto the spectacle lens.

In other words, it is suggested to determine the strength of the emission current to be used by the coating apparatus at the beginning of the current cycle and/or at the beginning of one or more evaporation steps of the current cycle using or based on the strength of the emission current from a previous cycle.

This provides the technical effect that the need for adjusting the emission current strength during the actual or present cycle of applying the coating onto the substrate may be minimized.

More specifically, experiments have shown that the emission current strength used during a previous cycle of the method are indicative for the emission current strength to be used in the current cycle in order to minimize the need for adjusting the emission current strength in the current cycle.

Since the need for adjusting the emission current strength in the current cycle is minimized, also a timespan during which the actual coating rate deviates from the target coating rate may be minimized. Therefore, the layer of the coating currently applied onto the substrate may be applied onto the substrate with a higher quality and thus the quality of the coating as a whole may be increased.

In the following further optional developments of the disclosure are explained in detail.

The method may comprise, in the current cycle of applying the coating onto the spectacle lens, control of a vapor deposition of the layer onto the spectacle lens such that the emission current of the initial strength is used for the vapor deposition at the beginning of the current cycle.

The control method may comprise, optionally per cycle, providing a target coating rate at with which the layer is to be vapor-deposited on the spectacle lens.

The control method may comprise, optionally continuously, determining an actual coating rate at which the layer is vapor-deposited on the spectacle lens, and, optionally continuously, controlling the actual strength of the emission current during the vapor deposition of the layer such that the actual coating rate corresponds to the (optionally predefined) target coating rate.

The function of the strength of the emission current used during the previous cycle of applying the coating onto a spectacle lens may involve an initial emission current used at the beginning of the previous cycle of applying the coating onto a spectacle lens and a final emission current used at the end of the previous cycle of applying the coating onto a spectacle lens. This may allow considering a progression of adaptations of the emission current during the previous cycle of applying the coating onto a spectacle lens and, hence, achieve a higher precision for the automated determining of the emission current for the current cycle of applying the coating to a spectacle lens.

The function may be adapted such that the initial strength of the emission current of the current cycle is determined to be in a range between the initial emission current and the final emission current used in the previous cycle of applying the coating onto the spectacle lens. This may allow for taking into consideration an anticipated variation of the emission current which may be required in the course of the current cycle of applying the coating to a spectacle lens. This may allow for achieving a higher precision.

The function may be based on a difference of the initial emission current and the final emission current used in the previous cycle of applying the coating onto the spectacle lens such that the initial strength of the emission current of the current cycle is determined based on the initial emission current of the previous cycle of applying the coating onto the spectacle lens and the difference. Optionally, the function may be adapted such as to automatedly determine the initial emission current of the current cycle as a sum of the initial or final emission current of the previous cycle and the at least a part of the difference between the initial and final emission current of the previous cycle. This may allow for achieving a higher precision and/or reducing a need of adjusting the emission current throughout the current cycle.

In other words, the best quality of the respective layer and thus the coating as a whole may be reached when the target coating rate and the actual coating rate match, i.e. are the same. To ensure this match a feedback control may be provided. Accordingly, the cycle may be started using the initial strength of the emission current determined as described above. At the beginning of the cycle the target coating rate and the actual coating rate should therefore substantially match. To ensure this during the whole cycle, the actual coating rate may be measured or determined, e.g. as described in the introductory part of this description, and the emission current strength may be controlled or adapted over the whole cycle in order to minimize a delta between the target and the actual coating rate.

The control method may comprise an automated setting of the determined initial strength of the emission current at the coating apparatus.

That is, the determined initial strength of the emission current may be sent to the coating apparatus or may be determined by the coating apparatus itself as described above, and additionally the coating apparatus may be configured to set or use the initial strength of the emission current without the need of a human operator to set or program the coating apparatus accordingly. The technical effect achieved by an automated setting of the determined initial strength of the emission current at the coating apparatus may therefore be formulated as to minimize downtime of the coating apparatus by eliminating or minimizing the need for manual process control.

The automated determination of the initial strength of the emission current for the current cycle may also be carried out as a function of at least one of the following parameters: a coating material from the previous and/or the current cycle, a target coating rate from the previous and/or the current cycle, an actual coating rate from the previous cycle, a target thickness of the layer from the previous and/or the current cycle, an actual thickness of the layer from the previous cycle, a target chamber pressure of the coating apparatus of the previous and/or to the current cycle, and an actual chamber pressure of the coating apparatus of the previous cycle. The chamber pressure relates to a vacuum pressure in the evacuated chamber of the coating device.

That is, the automated determination of the initial strength of the emission current may also take into account one or more of the parameters listed above. In one example, the initial current strength may be determined on a current strength of a previous cycle where the same material for the layer was used as the in the current cycle. In another example, the initial current strength may be determined on a current strength of a previous cycle where the same thickness of the layer was used as the in the current cycle. In another example, the previous cycle having the most common parameters with the current cycle may be determined and then the current strength of this cycle may be used in the determination of the initial current strength of the current cycle. The technical effect that is associated with this feature may be formulated as to further enhance the accuracy or precision in determining the initial strength of the emission current for the current cycle to thereby further reduce a potential delta between the actual and the target coating rate at the beginning of the current cycle.

The control method may comprise accessing a database of the coating apparatus, the database comprising the strength of the emission current used during the previous cycle, and optionally the at least one of the parameters mentioned above. The method may comprise using the strength of the emission current used during the previous cycle, and, optionally the at least one of the parameters mentioned above stored in the database for automated determining the initial strength of the emission current for the current cycle.

That is, a database may be provided which comprises parameters of previous cycles relevant for determining the initial strength of emission current for the current cycle. The database, which may be in the form of a logging file, may be stored in and/or outside the coating apparatus, but may be accessible by the computer or computing device determining the initial strength of emission current for the current cycle. Modern coating apparatuses already create and store such logging files. The technical effect associated with those features may be formulated as to make use of existing data, i.e. compatibility of the solution described herein with existing coating apparatuses may be ensured.

The control method may comprise, at least during the previous cycle, optionally also in the current cycle or all cycles, recording the strength of the emission current, and optionally the at least one of the parameters mentioned above.

The control method may comprise storing the recorded strength of the emission current, and optionally the at least one of the parameters mentioned above in the database of the coating apparatus.

That is, for example in a situation in which the coating apparatus carrying out the coating process is not by itself suitable to record and/or store the parameters of previous cycles relevant for determining the initial strength of emission current for the current cycle, respective steps may be carried out by the method. The technical effect associated with those features may be formulated as to ensure compatibility of the solution described herein with existing coating apparatuses not capable of creating the needed data basis.

The automated determining of the initial strength of the emission current may comprise determining an adjustment factor depending on the strength of the emission current used during the previous cycle, and optionally the at least one of the parameters mentioned above, and adjusting the emission current used during the previous cycle by the adjustment factor to obtain the initial strength of the emission current for the current cycle.

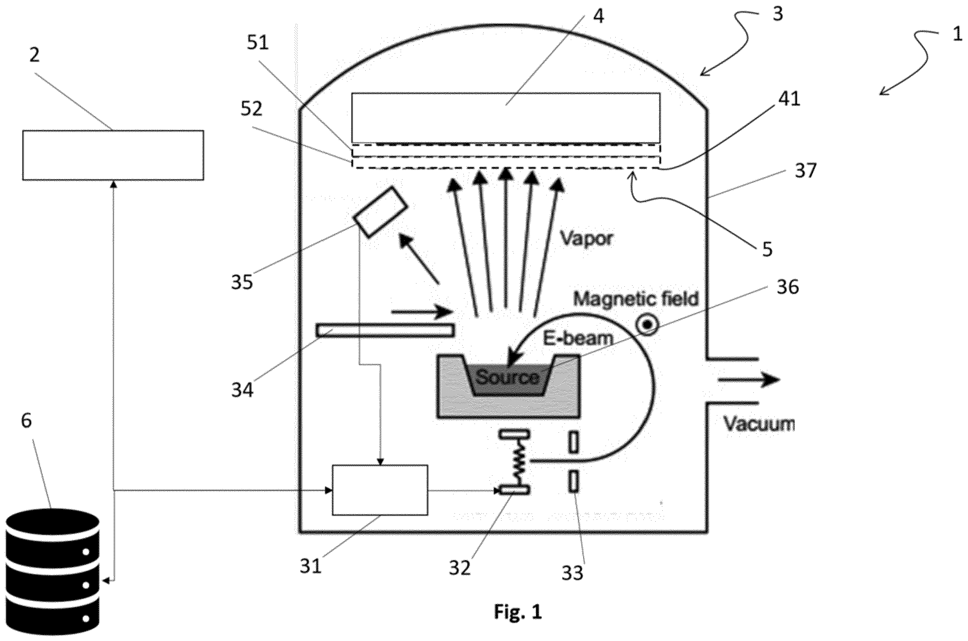

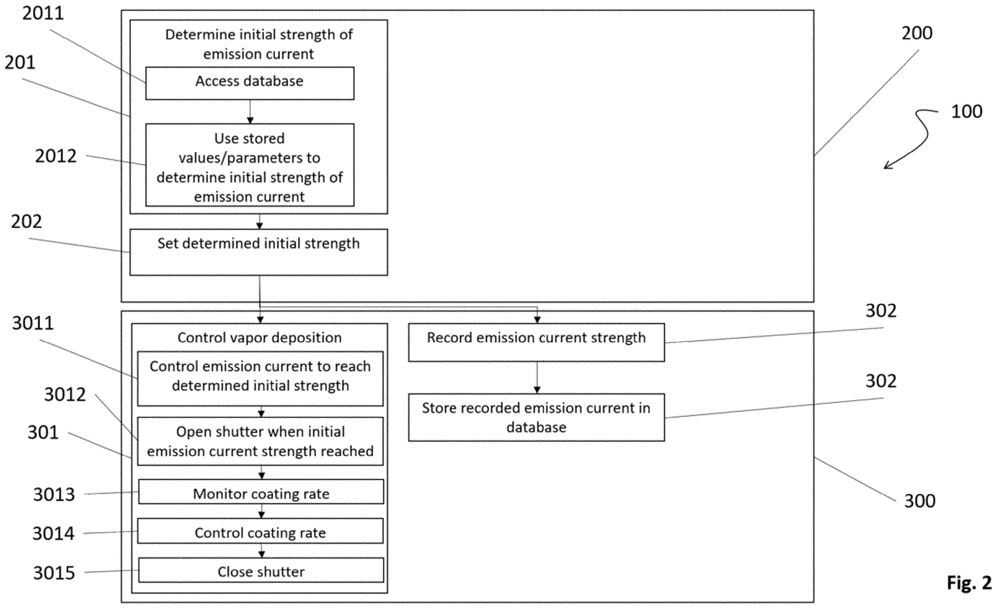

In the following optional embodiments of the disclosure are explained in detail with reference to figures 1 and 2.
- Fig. 1: shows schematically a device configured to control a coating apparatus in accordance with the present disclosure, and
- Fig. 2: shows schematically a flow chart of a method configured to control the coating apparatus in accordance with the present disclosure.

In figure 1 a system 1 is schematically shown. The system 1 comprises a computing device 2 and a coating apparatus 3.

The coating apparatus 3 comprises a control device 31, a cathode (filament) 32, an accelerator 33, a shutter 34, a QCM deposition monitor 35, an anode with a target or source material 36, and a housing 37 accommodating the aforementioned therein such that a not shown vacuum pump of the coating apparatus may generate a vacuum within the housing 37.

The control device 32 is connected to the computing device 2 such that the two devices 2, 31 may exchange data.

Inside the housing 37 one or more spectacle lenses 4 are arranged, wherein a coating 5 is to be applied, i.e. vapor deposited, onto a surface 41 of the one or more spectacle lenses 4 by the coating apparatus 2. The coating 5 comprises several layers, wherein only a first and a second layer 51, 52 are shown in figure 1.

The coating apparatus 2 is configured to vapor deposit the layer 51, 52 of the coating 5 onto the spectacle lens 4 by electron beam (E-beam) evaporation.

Applying the coating 5 onto the spectacle lens 4 will be described in further detail below also with respect to figure 2 showing a flowchart of a manufacturing method 100 for applying the coating 5 onto the spectacle lens 4.

The manufacturing method 100 comprises a computer-implemented method 200 configured to control the coating apparatus 2 and a method 300 of applying the coating onto the spectacle lens 4 by the coating apparatus 2. The manufacturing method 100 is carried out for every one of the layers 51, 52 forming the coating 5, i.e. the method comprises one cycle for each one of the layers 51, 52. In figure 2 the flowchart for one of those cycles is depicted.

In a first step 201 of the method 200 the computing device 2 carries out an automated determining of an initial strength of an emission current. The initial strength of the emission current is determined as a function of a strength of an emission current used during a previous cycle of applying the coating 5 onto the spectacle lens 4. Additionally, the initial strength of the emission current is determined as a function of at least one of the following parameters:
- a coating material from the previous and/or the current cycle,
- a target coating rate from the previous and/or the current cycle,
- an actual coating rate from the previous cycle,
- a target thickness of the layer from the previous and/or the current cycle,
- an actual thickness of the layer from the previous cycle,
- a target chamber pressure of the coating apparatus of the previous and/or to the current cycle, and
- an actual chamber pressure of the coating apparatus of the previous cycle.

In a first sub step 2011 of the first step 201 the computing device 2 accesses a database 6 of the coating apparatus 2, i.e. a database 6 that is accessible by the coating apparatus 3 for write and optionally read operations and by the computing device 2 for read and optionally write operations.

The database 6 may be stored in a storage medium being part of the coating apparatus 2, being part of the computing device 2, and/or being part of a cloud network. The same is true for the

The database 6 may be connected to the computing device 2 and/or the coating apparatus, optionally the control device 31, via a data connection. The data connection may be a wired or a wireless connection.

The same is true for the data connection between the computing device 2 and the coating apparatus 3, especially the control device 31. That is, while the computing device 2 is displayed in figure 1 as being located remotely from the coating apparatus 3, the computing device 2 may also form part of the coating apparatus 3, optionally the control device 31.

The database 6 may comprise one or more log(ging) files, e.g. one logging file for each cycle of applying the coating 5 onto the spectacle lens 4, i.e. one logging file for each layer 51, 52 of the coating 5 already applied onto the spectacle lens 4 by the coating apparatus 3. Additionally, or alternatively, it is possible that also logging files from other (not shown) coating apparatuses are stored in the database 6, which may also be accessible by the computing device 2 and which may also be used for computing the initial strength of the emission current.

In the present embodiment, the database 6 comprises an information specifying the strength of the emission current used during a previous cycle of applying the coating onto the substrate 4. More specifically, the database 6 comprises an information specifying the strength of the emission current used during applying the first layer 51 onto the surface 41 of the substrate 4. Additionally, the database 6 comprises a respective information specifying the at least one of the parameters described above.

As explained above, the computing device 2 accesses a database 6 in the first sub step 2011 of the first step 201 and thereby carries out a read operation so that the parameters stored in the database 6 may be used in a second sub step 2012 of the first step 201.

In the second sub step 2012 of the first step 201, the computing device 2 uses the strength of the emission current used during the previous cycle, and the at least one of the parameters mentioned above stored in the database 6 for automated determining of the initial strength of the emission current for the current cycle, i.e. for applying the second layer 52 onto the spectacle lens 4. The automated determining of the initial strength of the emission current comprises determining an adjustment factor depending on the strength of the emission current used at the end of the previous cycle and the at least one of the parameters mentioned above. The automated determining of the initial strength of the emission current further comprises adjusting the emission current used during the previous cycle by the adjustment factor to obtain the initial strength of the emission current for the current cycle.

In a second step 202 of the method 200 the computing device 2 sets the determined initial strength of the emission current at the coating apparatus 3. That is, the computing device 2 outputs the determined initial strength of the emission current to the control device 31 such that the control device 31 may use the determined initial strength of the emission current at the coating apparatus 3 as the target initial strength of the emission current to be reached latest when the second layer 52 is applied onto the first layer 51 of the coating 5.

As soon as the control device 31 receives the determined initial strength of the emission current a current cycle of applying the coating 5 onto the spectacle lens begins with a first step 301 of the method 300.

In the first step 301 of the method 300 the control device 31 controls a vapor deposition of the second layer 52 onto the first layer 51 arranged at the spectacle lens 4 such that an emission current of the initial strength is used for the vapor deposition at the beginning of the current cycle.

In a first sub step 3011 of the first 301 the control device uses the received initial strength of the emission current at the coating apparatus 3 as the target initial strength of the emission current to be reached latest when the second layer 52 is applied onto the first layer 51 of the coating 5. Therefore, the control device 31 causes a supply of the emission current to the cathode 32, wherein the strength of the emission current is increased/decreased until the target initial strength is reached.

The emission current causes the cathode 32 to emit an electron beam which is accelerated by the accelerator 33 and guided by the magnetic field inside the housing 37 towards the source or layer material 36 to be vapor depositioned onto the spectacle lens 4, here onto the first layer 51, as the second layer 52.

In a second sub step 3012 of the first step 300, the control device 31 causes the shutter 34 to be opened when or as soon as the control device 31 determines that the actual emission current has reached the target emission current. When the shutter 34 is in the closed position, the evaporated material is blocked from reaching the spectacle lens 4. As soon as the shutter 34 is opened, vapor deposition of the layer material 36 onto the first layer 51 starts and the second layer 52 is vapor deposited onto the first layer 51.

In a third sub step 3013 of the first step 301, the control device 31 continuously determines or monitors an actual coating rate at which the second layer 52 is vapor-deposited on the spectacle lens 4, i. e. on the first layer 51. The actual coating rate is determined as a function of a resonant frequency of the quartz 35.

In a fourth sub step 3014 of the first step 301, the control device 31 continuously controls the actual strength of the emission current during the vapor deposition of the second layer 52 such that the actual coating rate corresponds to or equals a predefined target coating rate.

In a fifth sub step 3015 of the first step 300, the control device 31 causes the shutter 34 to be closed when or as soon as the control device 31 determines that the second layer 52 is completed. The current cycle of the applying the coating 5 onto the spectacle lens 4 ends when the shutter 34 is closed.

During or simultaneously to the first step 301, a second step 302 of the method 300 is carried out by the control device 31. In the second step 302 the strength of the emission current and the at least one of the parameters mentioned above is recorded by the control device 31, optionally in a logging file. The strength of the emission current and the at least one parameter are at least recorded from the moment the shutter 34 opens (see sub step 3012) until the shutter 34 closes (see sub step 3015).

In a third step 303 of the method 300, the control device stores the recorded strength of the emission current and the recorded at least one of the parameters mentioned above in the database 6 of the coating apparatus 3, optionally as the logging file.

The stored logging file may therefore be accessed by the computing device in the next cycle of applying the coating onto the spectacle lens 4, when the method 100 starts again with the accessing the database 6 in the first step 201 of the method 200.

The function of the strength of the emission current used during the previous cycle of applying the coating 5 onto the spectacle lens 4 may involve an initial emission current used at the beginning of the previous cycle of applying the coating 5 onto the spectacle lens 4 and a final emission current used at the end of the previous cycle of applying the coating 5 onto the spectacle lens 4.

The function may be adapted such that the initial strength of the emission current of the current cycle is determined to be in a range between the initial emission current and the final emission current used in the previous cycle of applying the coating 5 onto the spectacle lens 4.

The function may be based on a difference of the initial emission current and the final emission current used in the previous cycle of applying the coating 5 onto the spectacle lens 4 such that the initial strength of the emission current of the current cycle is determined based on the initial emission current of the previous cycle of applying the coating 5 onto the spectacle lens 4 and the difference.

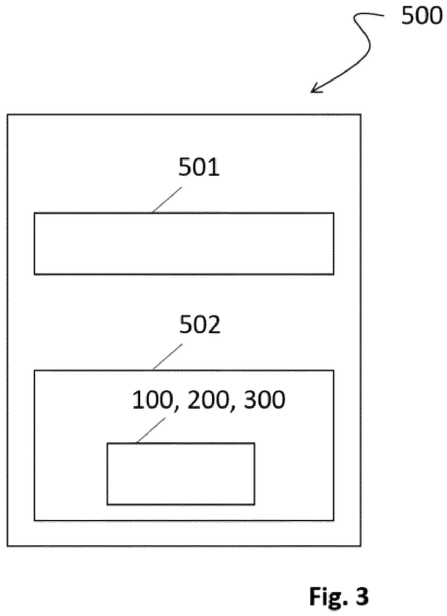

Figure 3 schematically depicts a method 500 for manufacturing a spectacle lens 4. The method comprises applying 501 a coating 5 onto the spectacle lens 4 in a coating apparatus 3. The method further comprises controlling 502 the coating apparatus 3 using a method 100, 200, 300 according to the optional embodiment illustrated in Figure 2 for applying the coating 5 onto the spectacle lens 4.

### Reference signs

- 1: Coating system
- 2: computing device
- 3: coating apparatus
- 31: control device
- 32: cathode
- 33: accelerator
- 34: shutter
- 35: quartz
- 36: layer/source material
- 37: housing/chamber
- 4: spectacle lens
- 41: surface of spectacle lens for coating
- 5: coating
- 51: first layer
- 52: second layer
- 6: database

- 100: manufacturing method
- 200: computer-implemented method configured to control the coating apparatus
- 201: determine initial strength of emission current
- 2011: access database
- 202: set determined initial strength
- 2012: use stored parameters to determine initial strength of emission current
- 300: method of applying the coating onto the spectacle lens
- 301: control vapor deposition
- 3011: control emission current to reach determined initial strength
- 3012: open shutter when initial emission current strength reached
- 3013: monitor coating rate
- 3014: control coating rate
- 3015: close shutter
- 302: record emission current strength
- 303: store recorded emission current in database

- 500: method for manufacturing a spectacle lens
- 501, 502: method steps

## Claims

1. A computer-implemented method (100, 200, 300) configured to control a coating apparatus (3), the coating apparatus (3) being configured to vapor deposit a layer (51, 52) of a coating (5) onto a spectacle lens (4) by electron beam evaporation, **characterized in that** the method comprises automated determining (201) of an initial strength of an emission current of a current cycle of applying the coating (5) onto the spectacle lens (4) as a function of a strength of an emission current used during a previous cycle of applying the coating (5) onto the spectacle lens (4).

2. The method (100, 200, 300) according to claim 1, **characterized in that** the method (100, 200, 300) comprises, in the current cycle of applying the coating (5) onto the spectacle lens (4), control (3011) of the vapor deposition of the layer (51, 52) onto the spectacle lens (4) such that the emission current of the initial strength is used for the vapor deposition at the beginning of the current cycle.

3. The method (100, 200, 300) according to claim 1 or 2, **characterized in that** the function of the strength of the emission current used during the previous cycle of applying the coating (5) onto the spectacle lens (4) involves an initial emission current used at the beginning of the previous cycle of applying the coating (5) onto the spectacle lens (4) and a final emission current used at the end of the previous cycle of applying the coating (5) onto the spectacle lens (4).

4. The method (100, 200, 300) according to claim 3, **characterized in that** the function adapted such that the initial strength of the emission current of the current cycle is determined to be in a range between the initial emission current and the final emission current used in the previous cycle of applying the coating (5) onto the spectacle lens (4).

5. The method (100, 200, 300) according to claim 3, **characterized in that** the function is based on a difference of the initial emission current and the final emission current used in the previous cycle of applying the coating (5) onto the spectacle lens (4) such that the initial strength of the emission current of the current cycle is determined based on the initial emission current of the previous cycle of applying the coating (5) onto the spectacle lens (4) and the difference.

6. The method (100, 200, 300) according to any of the preceding claims,
**characterized in that** the method (100, 200, 300) comprises an automated setting (202) of the determined initial strength of the emission current at the coating apparatus (3).

7. The method (100, 200, 300) according to any one of the preceding claims,
**characterized in that** automated determination (201) of the initial strength of the emission current for the current cycle is also carried out as a function of at least one of the following parameters:
- a coating material from the previous and/or the current cycle,
- a target coating rate from the previous and/or the current cycle,
- an actual coating rate from the previous cycle,
- a target thickness of the layer from the previous and/or the current cycle,
- an actual thickness of the layer from the previous cycle,
- a target chamber pressure of the coating apparatus (3) of the previous and/or to the current cycle, and
- an actual chamber pressure of the coating apparatus (3) of the previous cycle.

8. The method (100, 200, 300) according to any of the preceding claims,
**characterized in that** the method (100, 200, 300) comprises:
- accessing (2011) a database (6) of the coating apparatus (3), the database (6) comprising the strength of the emission current used during the previous cycle and, as far as being dependent on claim 6, the at least one of the parameters mentioned in claim 6, and
- using (2012) the strength of the emission current used during the previous cycle, and, as far as being dependent on claim 6, the at least one of the parameters mentioned in claim 6 stored in the database (6) for automated determining (201) the initial strength of the emission current for the current cycle.

9. The method (100, 200, 300) according to any of the preceding claims,
**characterized in that** the method (100, 200, 300) comprises, at least during the previous cycle, recording (302) the strength of the emission current, and as far as being dependent on claim 6, the at least one of the parameters mentioned in claim 6.

10. The method (100, 200, 300) according to claim 9, when being dependent on claim 8, **characterized in that** the method comprises storing (303) the recorded strength of the emission current, and as far as being dependent on claim 4, the at least one of the parameters mentioned in claim 4 in the database (6) of the coating apparatus (3).

11. The method (100, 200, 300) according to any one of the preceding claims,
**characterized in that** the automated determining (201) the initial strength of the emission current comprises:
- determining an adjustment factor depending on the strength of the emission current used during the previous cycle and, as far as being dependent on claim 6, the at least one of the parameters mentioned in claim 6, and
- adjusting the emission current used during the previous cycle by the adjustment factor to obtain the initial strength of the emission current for the current cycle.

12. A device (2) configured to control a coating apparatus (3), the coating apparatus (3) being configured to vapor deposit a layer (51, 52) of a coating (5) onto a spectacle lens (4) by electron beam evaporation, **characterized in that** the device (2) is configured to carry out an automated determining of an initial strength of an emission current of a current cycle of applying the coating (5) on the spectacle lens (4) as a function of a strength of an emission current used during a previous cycle of applying the coating (5) onto the spectacle lens (4).

13. A computer program, wherein the computer program comprises instructions which, when the program is executed by a computer (2), cause the computer (2) to control a coating apparatus (3), the coating apparatus (3) being configured to vapor deposit a layer (51, 52) of a coating (5) onto a spectacle lens (4) by electron beam evaporation, **characterized in that** controlling (200) the coating apparatus (3) comprises an automated determining of an initial strength of an emission current of a current cycle of applying the coating (5) onto the spectacle lens (4) as a function of a strength of an emission current used during a previous cycle of applying the coating onto (5) the spectacle lens (4).

14. A computer-readable storage medium, wherein the medium comprises instructions which, when executed by a computer (2), cause the computer (2) to control a coating apparatus (3), the coating apparatus (3) being configured to vapor deposit a layer (51, 52) of a coating (5) onto a spectacle lens (4) by electron beam evaporation, **characterized in that** controlling (200) the coating apparatus (3) comprises an automated determining of an initial strength of an emission current of a current cycle of applying the coating (5) onto the spectacle lens (4) as a function of a strength of an emission current used during a previous cycle of applying the coating onto (5) the spectacle lens (4).

15. A method (500) for manufacturing a spectacle lens (4), the method comprising applying a coating (5) onto the spectacle lens (4) in a coating apparatus (3), **characterized in that** the method comprises controlling the coating apparatus (3) using a method (100, 200, 300) according to any one of the claims 1 to 11 for applying the coating (5) onto the spectacle lens (4).
